# EUROPEAN PATENT APPLICATION

(11) **EP 4 797 938 A1**
(43) Date of publication of application: **26.08.2026**
(21) Application number: 25225274.7
(22) Date of filing: 18.12.2025
(51) Int. Cl.: H10W 70/63, H10W 70/685, H10W 72/90

(54) **METHODS AND APPARATUS TO COMPENSATE FOR IMPEDANCE AND REDUCE CROSSTALK IN INTEGRATED CIRCUIT PACKAGES**

(30) Priority: 21.02.2025 WO PCT/CN2025/078493; 28.04.2025 US 202519191843
(71) Applicant: Intel Corporation, Santa Clara, CA 95054 (US)
(72) Inventor: CHANDRASEKHAR, Vishal, San Jose, 95133 (US); FIERRO PINEDA, Pedro Ivan, Los Gatos, 95032 (US); FULCHER, Charles, Olympia, 98501 (US); GUERRERO, Raul Manuel, Gilbert, 85298 (US); IPARRAGUIRRE, Daniel, Portland, 97224 (US); MEKONNEN, Yidnekachew, Chandler, 85286 (US); YAN, Chenghai, Shanghai, 200241 (CN); YIN, Maoxin, Shanghai, 200241 (CN); ZHU, Yanjie, El Dorado Hills, 95762 (US)
(74) Representative: 2SPL Patentanwälte PartG mbB

(57) **Abstract**

Systems, apparatus, articles of manufacture, and methods to compensate for impedance and reduce crosstalk in integrated circuit packages are disclosed. An example apparatus includes a metal interconnect within a substrate of an integrated circuit package. The metal interconnect includes a contact pad in a first metal layer of the substrate and a via pad in a second metal layer of the substrate. The metal interconnect defines a conductive path for an electric signal that is to pass through both the contact pad and the via pad. The example apparatus further includes a conductive material having a length defining a segment of the conductive path between the contact pad and the via pad. At least a portion of the length of the conductive material extends along a course that corresponds and is adjacent to a portion of a perimeter of the contact pad.

## Description

### RELATED APPLICATION(S)

This patent claims the benefit of International Patent Application No. PCT/CN2025/078493, which was filed on February 21, 2025. International Patent Application No. PCT/CN2025/078493 is hereby incorporated herein by reference in its entirety. Priority to International Patent Application No. PCT/CN2025/078493 is hereby claimed .

### BACKGROUND

In many integrated circuit packages, one or more semiconductor dies are mechanically and electrically coupled to an underlying package substrate. Many such package substrates include a ball grid array (BGA) or a land grid array (LGA) to enable the package to be mechanically and electrically coupled to a printed circuit board.

### BRIEF DESCRIPTION OF THE DRAWINGS

FIG. 1 illustrates an example integrated circuit (IC) package constructed in accordance with teachings disclosed herein.
FIG. 2 is a top view of an example arrangement of contact pads constructed in accordance with teachings disclosed herein.
FIG. 3 is a top perspective view of the example arrangement of contact pads of FIG. 2 represented in spatial relationship to surrounding conductive features.
FIG. 4 is a cross-sectional view of the conductive features associated with the first and second contact pads of FIG. 3 taken along line 4-4 of FIG. 2.
FIG. 5 is a cross-sectional view of the conductive features associated with the second and fourth contact pads of FIG. 3 taken along line 5-5 of FIG. 2.
FIG. 6 is a top view of an example metal interconnect constructed in accordance with teachings disclosed herein.
FIG. 7 is a top view of another example metal interconnect constructed in accordance with teachings disclosed herein.
FIG. 8 is a top perspective view of another example metal interconnect constructed in accordance with teachings disclosed herein.
FIG. 9 is a top perspective view of another example metal interconnect constructed in accordance with teachings disclosed herein.
FIG. 10A is a top view of another example metal interconnect constructed in accordance with teachings disclosed herein.
FIG. 10B is a top view of another example metal interconnect constructed in accordance with teachings disclosed herein.
FIG. 11 is a top perspective view of another example metal interconnect constructed in accordance with teachings disclosed herein.
FIG. 12 is a flowchart representative of an example method of manufacturing the example IC package of FIG. 1 that includes any of the example lengths of conductive material as disclosed in connection with FIGS. 2-11.
FIG. 13 is a top view of a wafer including dies that may be included in an IC package constructed in accordance with teachings disclosed herein.
FIG. 14 is a cross-sectional side view of an IC device that may be included in an IC package constructed in accordance with teachings disclosed herein.
FIG. 15 is a cross-sectional side view of an IC device assembly that may include an IC package constructed in accordance with teachings disclosed herein.
FIG. 16 is a block diagram of an example electrical device that may include an IC package constructed in accordance with teachings disclosed herein.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

Crosstalk, such as Far-End Crosstalk (FEXT), and Inter-Symbol Interference (ISI) impose significant limitations in the performance of communications with and/or within an integrated circuit (IC) package. Increasing data-rate targets and reducing geometries make the channel crosstalk (e.g., FEXT) effects more significant and harder to address. Furthermore, certain geometries in integrated circuits produce impedance discontinuities in which sudden drops in impedance occur. Such impedance discontinuities drive reflections, due to impedance mismatches, and ISI.

A significant contributing factor to overall FEXT and ISI is the presence of large vertical structures along a signal path to and/or from semiconductor chips or dies in an IC package. Examples of such large vertical structures include plated through-holes (PTHs) within a package and interconnects. In some examples, interconnects may be interconnects (e.g., contacts) between different components in a package (e.g., mid-level interconnects between an interposer and a package substrate), and interconnects (e.g., contacts) to connect a package with external components (e.g., second level interconnects such as ball grid arrays (BGAs), land grid arrays (LGAs), and the like, which connect a package to an external socket and/or circuit board (e.g., motherboard)).

Large vertical structures may also create changes in impedance, resulting in impedance discontinuities. Impedance discontinuities, such as large impedance drops resulting from the presence of large vertical structures are becoming a greater problem in high performance computing (e.g., big data application, artificial intelligence (AI) applications). Specifically, high performance computing demands high data rates, which are significantly impacted by impedance discontinuities. High data rates are achieved by increasing the size of IC packages and the associated number of connections (e.g., individual number of balls in a BGA and/or lands in an LGA) between the packages and a motherboard. Increasing the number of contacts increases the number of large vertical structures, which has an impact on impedance. Additionally, increasing the number of contacts and an associated increase in package size requires an increase in compressive force to ensure reliable contact between the package contacts (e.g., BGA balls) on an underlying socket and/or circuit board. However, this increased compressive force is likely to over compress at least some balls and cause them to deform and widen, thereby resulting in a larger impedance drop (e.g., a larger impedance discontinuity), which impacts data rates.

Several techniques have been employed in the past to mitigate against or reduce impedance discontinuities and crosstalk (e.g., FEXT). One such approach is to increase impedance near a location where an impedance drop occurs thereby mitigating the impedance discontinuity by reducing or offsetting the impedance drop. One way to achieve such an impedance increase is to reduce capacitance because impedance decreases as capacitance increases. One approach to reducing capacitance at a contact associated with large vertical structures (e.g., a ball in a BGA or a land in an LGA) is to construct packages with metal void regions in the metal layers above an associated contact. As used herein, a metal void region refers to a region in which metal interconnects (e.g., planes, traces, vias, etc.) are generally excluded except for metal features defining the internal interconnect (for signal transmission) corresponding to a given contact. The larger the metal void region, the more the capacitance is reduced or attenuated, thereby resulting in less change in impedance (e.g., less capacitance corresponds to greater impedance and, thus, a smaller impedance drop) across the associated contacts beneath such regions. However, the void regions cannot be increased indefinitely, but are limited due to other design considerations (e.g., using the space for package routing and/or reducing the overall package size). Thus, enlargement of metal void regions is often not a viable option to enable a further reduction in impedance discontinuities.

One known approach to reduce crosstalk (e.g., FEXT) involves the construction of packages with capacitive compensation structures (sometimes referred to as coupled-via structures) that include a stub that is electrically connected to and extends away from a metal interconnect (e.g., signal path) associated with a first large vertical structure (e.g., BGA ball, LGA land, PTH, etc.) and towards an adjacent second metal interconnect (e.g., another signal path). As used herein, a stub refers to a portion of conductive material that branches off from a portion of a metal interconnect defining a conductive path along which electrical signals may travel. A stub does not define the path for electrical signals but merely branches off from such a path. The stub can be capacitively coupled to an adjacent metal interconnect. Such capacitive coupling of a stub branching off a first interconnect with a second interconnect serves to reduce crosstalk between the interconnects.

More particularly, the large vertical structures noted above produce a large amount of inductive crosstalk with a negative polarity. Coupled-via technology (in which one signal path is capacitively coupled with another signal path via a stub) provides a capacitive crosstalk component with a positive sign that cancels out or at least reduces the inductive negative-sign crosstalk. However, coupled-via technology generates a capacitive discontinuity as a byproduct. As a result, coupled-via technology added adjacent to the large vertical structures results in a larger impedance drop that exacerbates the ISI effects in the channel. In other words, there is a tradeoff between reducing crosstalk and reducing impedance discontinuity because the stub associated with coupled-via technology produces and/or increases impedance discontinuity. Moreover, coupled-via technology uses up space within a package that could otherwise be used for other components, signal routing and/or to reduce the overall size of the package.

Examples disclosed herein include one or more inductive compensation structures positioned proximate to large vertical structures (e.g., balls of a BGA, lands of an LGA, PTHs, etc.) to compensate for the impedance discontinuity induced by such large structures. Example inductive compensation structures can be used to reduce impedance discontinuities arising from the shape, size, and/or structure of the associated large vertical structure itself. Additionally or alternatively, example inductive compensation structures can be structured (e.g., tuned) to also compensate for coupled-via structures. That is, disclosed examples can be used in combination with coupled-via technology or used independent of it. Additionally or alternatively, example inductive compensation structures can be structured (e.g., tuned) to attenuate the FEXT, depending on a given performance target.

Rather than reducing capacitance (which is inversely related to impedance), examples disclosed herein function to increase inductance (which is directly related to impedance) to reduce impedance discontinuities. In some examples, the inductive compensation structures are characterized by an elongate length of conductive material (e.g., a metal arm or trace, also referred to herein as an inductive loop or inductive curl) that defines a segment or portion of a conductive path for an electrical signal associated with a given large vertical structure. That is, unlike a stub that branches off from a conductive path used in coupled-via technology, the lengths of conductive material disclosed herein form part of the conductive path. In some examples, such lengths of conductive material follow a course generally corresponding and adjacent to a perimeter of the associated contact pad (e.g., a contact pad associated with a BGA ball, and LGA land, or a PTH). More particularly, in some examples, the lengths of conductive material are in the same metal layer as the contact pads (e.g., the base metal layer of a package when associated with a BGA or LGA) and extend around the perimeter of the contact pad. Inasmuch as the lengths of conductive material are within the base metal layer of such examples, the lengths of conductive material do not use up space for package routing, which is typically implemented in metal layers inside of the base metal layer. Furthermore, positioning inductive compensation structures (e.g., example lengths of conductive material) within the base metal layer (where the associated contact pad is located, places the inductive compensation structure close to the source of the impedance discontinuity for more effective compensation. Example inductive compensation structures (e.g., lengths of conductive material or inductive curls) in the base metal layer are sometimes referred to herein as curl-on-base layer (COB) structures.

Additionally or alternatively, in some examples, the inductive compensation structures (e.g., lengths of conductive material) extend along a course corresponding and adjacent to the perimeter of a contact pad in one or more metal layers above (e.g., internal to) the base metal layer where the contact pad is provided. In some such examples, the elongate course or path of the conductive material can be within an area defined by the perimeter of the contact pad. That is, in some examples, the disclosed lengths of conductive material are provided within the metal void region. Example inductive compensation structures (e.g., lengths of conductive material or inductive curls) in the metal void region are sometimes referred to herein as curl-on-void (COV) structures. Some example COV structures disclosed herein are comparable to a solenoid in that they are characterized by a loop or coil of metal within the void region to connect a contact pad with the rest of the routing for the conductive signal path associated with the contact pad.

In some examples, the lengths of conductive material (e.g., the inductive loop or curl) is aligned with an outer boundary of the metal void region (e.g., adjacent the perimeter of the contact pad) to increase (e.g., maximize) the advantage of the void region by increasing (e.g., maximizing) the radius or spiral of the loop or coil for increased (e.g., maximum) inductance. Inasmuch as COV structures disclosed herein can be implemented in existing metal void regions, such structures do not use up any space for package routing. The resulting impedance compensation of COV structures (by increasing inductance), in combination with the LC filtering effect achieves an effective ISI reduction and crosstalk attenuation resulting in a significant full-channel margin improvement.

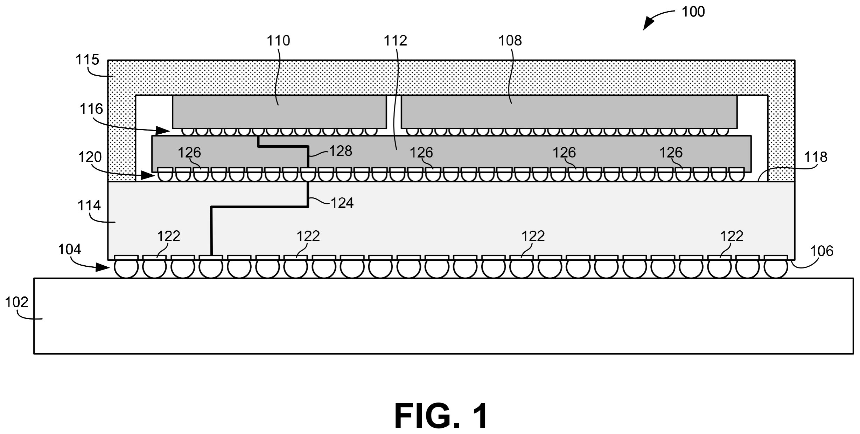

FIG. 1 illustrates an example integrated circuit (IC) package 100 constructed in accordance with teachings disclosed herein. In the illustrated example, the IC package 100 is electrically coupled to an underlying substrate 102 via an array of first contacts 104 on a package mounting surface 106 (e.g., a bottom surface, an external surface) of the package 100. In some examples, the substrate 102 can be implemented by a printed circuit board (PCB) or a package substrate (e.g., the IC package 100 is part of another larger package). In the illustrated example, the first contacts 104 are represented as balls (e.g., solder balls) in a ball grid array (BGA). However, in other examples, the IC package 100 includes pads, lands, pins, and/or any other type(s) of contacts, in addition to or instead of the balls shown to enable the electrical coupling of the IC package 100 to the substrate 102. In this example, the package 100 includes two semiconductor dies 108, 110 (e.g., silicon dies), sometimes also referred to as chips or chiplets, that are mounted on an interposer 112. In some examples, the interposer 112 includes a semiconductor substrate and, thus, can also be considered a semiconductor (e.g., silicon) die. In some examples, the interposer 112 includes a glass substrate. In the illustrated example, the interposer 112 is mounted on a package substrate 114. In this example, the interposer 112 and the two dies 108, 110 are enclosed by a package lid 115 (e.g., a mold compound, an integrated heat spreader (IHS)). In some examples, the package lid 115 is omitted, thereby leaving the semiconductor dies 108, 110 exposed or bare.

While the example IC package 100 of FIG. 1 includes two dies 108, 110, in other examples, the IC package 100 may have only one die or more than two dies. Further, in some examples, the dies 108, 110 are mounted directly to the package substrate 114 and the interposer 112 is omitted. The dies 108, 110 can provide any suitable type of functionality (e.g., data processing, memory storage, etc.). In some examples, one or both of the dies 108, 110 are implemented by a die package including multiple dies arranged in a stacked formation. For example, the die 110 can include a stack of Dynamic Random Access Memory (DRAM) dies arranged on top of a memory controller die to form a memory die stack.

As shown in the illustrated example, each of the dies 108, 110 is electrically and mechanically coupled to the interposer 112 via corresponding arrays of second contacts 116. Similarly, the example interposer 112 is electrically and mechanically coupled on a die mounting surface 118 (e.g., an upper surface, a top surface, etc.) of the package substrate 114 via an array of third contacts 120. In FIG. 1, the second and third contacts 116, 120 are shown as bumps. In some examples, the second and third contacts 116, 120 can include solder joints, micro bumps, combinations of metallic (e.g., copper) pillars and solder, etc. In other examples, the second and third contacts 116, 120 include directly bonded or "hybrid bonded" metallic interconnects. In other examples, the second and third contacts 116, 120 may be any other type of electrical connection in addition to or instead of the bumps shown (e.g., balls, pins, pads, pillars, wire bonding, etc.). The electrical connections between the dies 108, 110 and the interposer 112 (e.g., the second contacts 116) are sometimes referred to as first level interconnects. By contrast, the electrical connections between the IC package 100 and the substrate 102 (e.g., the first contacts 104) are sometimes referred to as second level interconnects. The electrical connections between the interposer 112 (e.g., the third contacts 120) are sometimes referred to as a second layer of first level interconnects and/or mid-level interconnects.

As shown in the illustrated example of FIG. 1, the first contacts 104 are associated with corresponding first contact pads 122 in a base metal layer of the package substrate 114 along the package mounting surface 106. The first contact pads 122 define the beginning of first internal interconnects 124 (only one is shown in the illustrated example) extending through the package substrate 114 and electrically coupled to corresponding ones of the third contacts 120 at the die mounting surface 118 of the package substrate 114. In this example, the third contacts 120 are associated with corresponding second contact pads 126 in a base metal layer of the interposer 112. The second contact pads 126 define the beginning of second internal interconnects 128 (only one is shown in the illustrated example) extending through the interposer 112 to corresponding ones of the second contacts 116 on the semiconductor dies 108, 110. In this manner, as shown in FIG. 1, the internal interconnects 124, 128 and the associated contacts 104, 116, 120 and associated contact pads 122, 126 define continuous metal interconnects electrically coupling the semiconductor dies 108, 110 with the substrate 102.

In some examples, the IC package 100 includes additional passive components, such as surface-mount resistors, capacitors, and/or inductors disposed on the package mounting surface 106 of the package substrate 114 and/or the die mounting surface 118 of the package substrate 114.

In many existing IC packages, the contacts associated with second level interconnects (e.g., the first contacts 104 of FIG. 1 coupling the package 100 to the substrate 102) as well as mid-level interconnects (e.g., the third contacts 120 of FIG. 1 coupling the interposer 112 to the package substrate 114) introduce two challenges from a signal integrity perspective. The first challenge is the introduction of an impedance discontinuity or mismatch along a signal path at the point of the contacts. For instance, with reference to the example IC package 100 of FIG. 1, a signal travelling from one of the dies 108, 110, through the interposer 112 and the package substrate 114, to the substrate 102 will experience a first drop in impedance at the third contacts 120 and a second drop or discontinuity in impedance at the first contacts 104. Due to the larger size of the first contacts 104, relative to the third contacts 120, the impedance drop at the first contacts 104 will be greater than the impedance drop or discontinuity at the third contacts 120. The second challenge introduced by contacts between components of an IC package pertains to crosstalk between different signal paths associated with adjacent contacts. As used herein, the term "adjacent," used in the context of two contacts being adjacent to one another, means that the two contacts are next to one another without another contact positioned directly therebetween. Examples disclosed herein mitigate these challenges through the implementation of inductive compensation structures as detailed further below. Although the second level interconnects (e.g., the first contacts 104 of FIG. 1) and the mid-level interconnects (e.g., the third contacts 120 of FIG. 1) are identified above as locations of significant concern for impedance discontinuities, similar challenges can arise at other locations such as at first level interconnects (e.g., the second contacts 116 of FIG. 1 between the dies 108, 110 and the interposer 112) and/or within any one or more of the dies 108, 110, the interposer 112, and the package substrate 114. Accordingly, example inductive compensation structures can be at any of these locations in accordance with teachings disclosed herein. However, the size of metal features within semiconductor dies are often much smaller than in an interposer and/or in a package substrate and, therefore, result in smaller impedance discontinuities that are often of less concern than larger features elsewhere in an IC package.

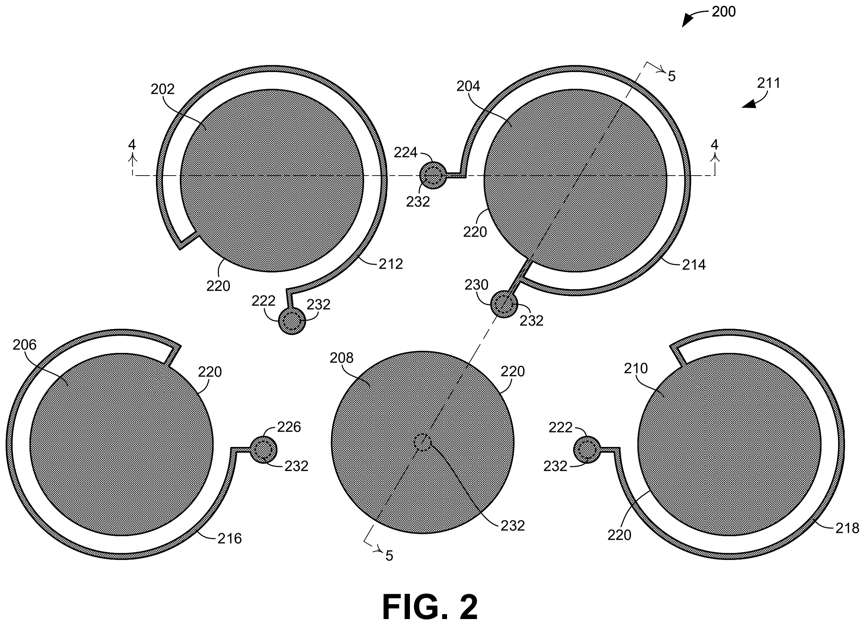

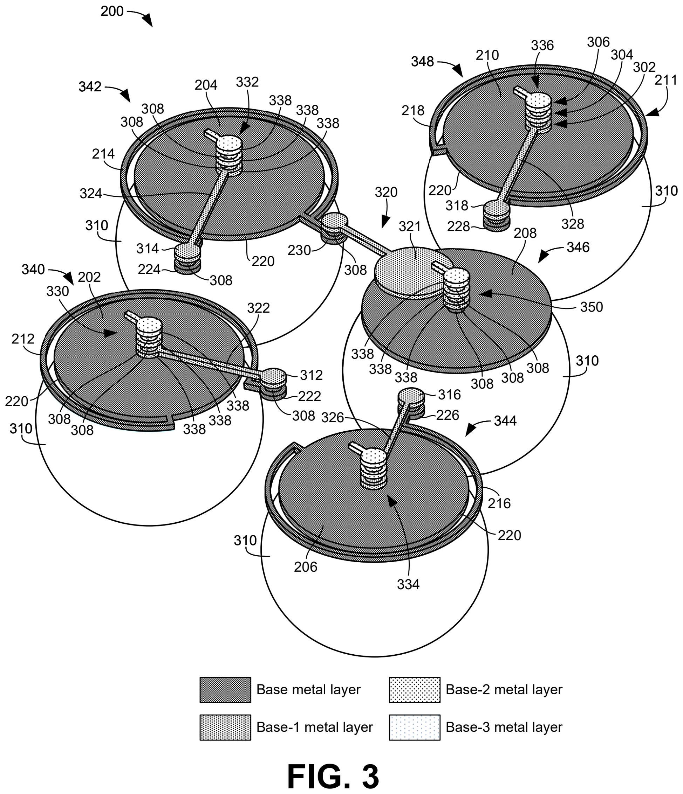

FIG. 2 is a top view of an example arrangement 200 of contact pads 202, 204, 206, 208, 210 (e.g., a first contact pad 202, a second contact pad 204, a third contact pad 206, a fourth contact pad 208, and a fifth contact pad 210) constructed in accordance with teachings disclosed herein. The contact pads 202, 204, 206, 208, 210 represent an example implementation of the contact pads 122 associated with the first contacts 104 in FIG. 1 and/or the contact pads 126 associated with the third contacts 120 in FIG. 1. In FIG. 2, all of the features shown are in the same metal layer (e.g., a base metal layer 211). FIG. 3 is a top perspective view of the example arrangement 200 of contact pads 202, 204, 206, 208, 210 of FIG. 2 represented in spatial relationship to surrounding conductive features (e.g., insulating materials such as dielectric layers are omitted in FIG. 3 for the sake of clarity). More particularly, FIG. 3 illustrates three additional metal layers 302, 304, 306 on one side (e.g., above) the base metal layer (e.g., a base-1 metal layer 302, a base-2 metal layer 304, and a base-3 metal layer 306) with intervening metal vias 308 extending between corresponding via pads 222, 224, 226, 228, 230, 312, 314, 316, 318, 338 defined within the different metal layers 211, 302, 304, 306.

As used herein, a via pad is defined as an area of metal within a given metal layer (e.g., the metal layers 211, 302, 304, 306) at which a metal via (e.g., the metal vias 308) is located to electrical couple the metal layer with another metal layer. In the illustrated example of FIG. 2, the dashed circles 232 represent the location of the metal vias 308 connected to the base metal layer 211 (the only metal layer shown in FIG. 2). In the illustrated examples, the via pads 222, 224, 226, 228, 230, 312, 314, 316, 318, 338 are larger than the metal vias 308. However, in some examples, the via pads 222, 224, 226, 228, 230, 312, 314, 316, 318, 338 can be the same size (e.g., have the same diameter) as the metal vias 308. As shown in the illustrated example, only the fourth contact pad 208 has a metal via directly coupled to its surface (e.g., the fourth contact pad constitutes a via pad as defined above). By contrast, metal vias 308 electrically coupled to the other contact pads 202, 204, 206, 210 are indirectly coupled to the contact pads 202, 204, 206, 210 by way of respective lengths of conductive material 212, 214, 216, 218 (e.g., metal arms, inductive loops, inductive curls, inductive traces, inductive compensation structures) that branch off and extend at least part way around the contact pads 202, 204, 206, 210. Inasmuch as the lengths of conductive material 212, 214, 216, 218 are within the base metal layer 211, the lengths of conductive material 212, 214, 216, 218 can also be referred to curl-on base layer (COB) structures. In this example, the lengths of conductive material 212, 214, 216, 218 function as inductors. The lengths of conductive material 212, 214, 216, 218, via pads 222, 224, 226, 228, 230, 312, 314, 316, 318, 338, metal vias 308, and other associated metal features electrically coupled together provide individual metal interconnects 340, 342, 344, 346, 348 defining a conductive path to carry electrical signals and/or power through an associated substrate. That is, in this example, the metal interconnects 340, 342, 344, 346, 348 correspond to the internal interconnects 124 within the package substrate 114 of FIG. 1 and/or the internal interconnects 128 within the interposer 112 of FIG. 1.

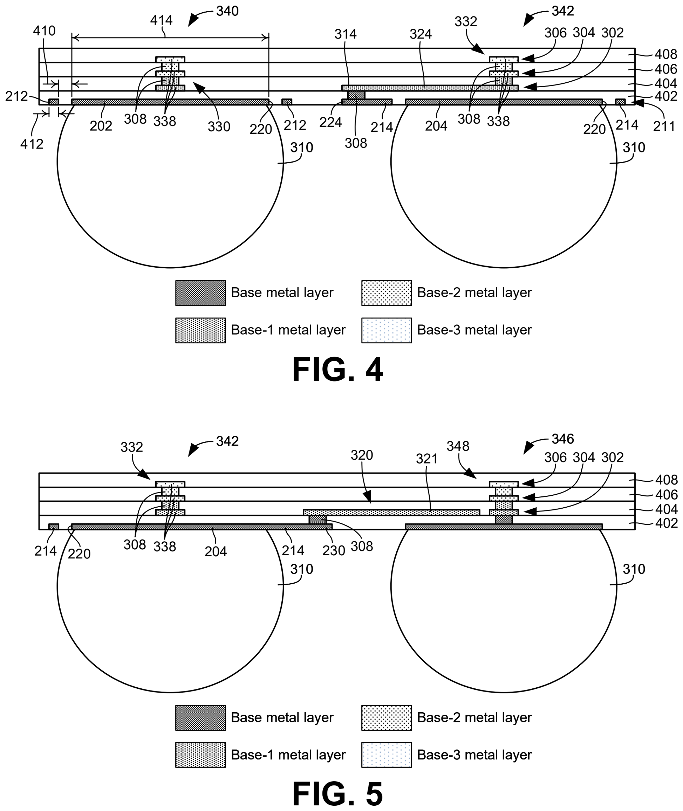

For purposes of clarity, each of the different metal layers 211, 302, 304, 306 in FIG. 3 are visually distinguished by different shading with the base metal layer 211 being the darkest and each successive layer being drawn with a lighter shading. Further, for the sake of clarity, the metal vias 308 directly above a given metal layer 211, 302, 304, 306 are drawn with the same shading as the underlying metal layer 211, 302, 304, 306. Thus, the shading should not be viewed as indicating different materials. In some examples, all of the metal layers 211, 302, 304, 306 include the same material (e.g., copper). However, in other examples, one or more of the metal layers 211, 302, 304, 306 can include different materials than the other metal layers. Further, the metal vias 308 can include the same or different conductive material as the metal layers 211, 302, 304, 306. The different metal layers 211, 302, 304, 306 and the structure of the associated conductive features are further clarified with reference to FIGS. 4 and 5. Specifically, FIG. 4 is a cross-sectional view of the conductive features associated with the first and second contact pads 202, 204 taken along line 4-4 of FIG. 2. FIG. 5 is a cross-sectional view of the conductive features associated with the second and fourth contact pads 204, 208 taken along line 5-5 of FIG. 2. The shading of the different metal layers 211, 302, 304, 306 shown in FIGS. 4 and 5 follows the shading used in FIG. 3 as outlined above. FIGS. 4 and 5 show the layers of dielectric material 402, 404, 406, 408 (e.g., dielectric layers) on top of respective ones of the metal layers 211, 302, 304, 306 to electrically isolate the metal layers (except for the metal vias 308 extending therebetween.

FIGS. 3-5 also illustrate contacts 310 on the side the base metal layer 211 that is opposite to the three other metal layers 302, 304, 306 (e.g., below the base metal layer 211 in the illustrated examples). In this example, the contacts 310 represent an example implementation of the first contacts 104 and/or the third contacts 120 of FIG. 1.

As noted above and shown most clearly in FIGS. 2 and 3, the first, second, third, and fifth contact pads 202, 204, 206, 210 are coupled to respective lengths of conductive material 212, 214, 216, 218 that branch out from a perimeter 220 (e.g., edge) of the contact pads 202, 204, 206, 210 and extend along a portion of the perimeter 220 while remaining spaced therefrom. More particularly, in some examples, the lengths of conductive material 212, 214, 216, 218 are spaced apart from the corresponding contact pads 202, 204, 206, 210 along a full extent of the lengths of conductive material 212, 214, 216, 218 except at the point of attachment at one end. As shown in the illustrated example, the opposite end of each length of conductive material 212, 214, 216, 218 includes a via pad 222, 224, 226, 228 at which a metal via 308 is positioned to electrically couple the length of conductive material 212 and the associated contact pad 202, 204, 206, 210 with the next metal layer up from the underlying contact 310 (e.g., the base-1 metal layer 302). In this example, the base-1 metal layer 211 includes additional via pads 312, 314, 316, 318 aligned with the via pads 222, 224, 226, 228 at the ends of the respective lengths of conductive material 212, 214, 216, 218 and electrical coupled thereto by metal vias 308 extending therebetween. In this example, the base-1 metal layer 211 includes a trace 322, 324, 326, 328 that extends from the via pad 312, 314, 316, 318 coupled to the base metal layer 211 to respective via stacks 330, 332, 334, 336 aligned with centers of the associated contact pads 202, 204, 206, 208. As shown in the illustrated example, the via stacks 330, 332, 334, 336 include metal vias 308 connecting additional via pads 338 in each metal layer 302, 304, 306 above the base metal layer 211. Based on this arrangement, the conductive path for electrical signals transmitted along each of the metal interconnects 340, 342, 344, 348 pass (beginning at the top) through the corresponding via stack 330, 332, 334, 336, along the corresponding trace 322, 324, 326, 328, down through another metal via 308 and the corresponding via pads 222, 224, 226, 228 at the ends of the respective lengths of conductive material 212, 214, 216, 218, and along the lengths of conductive material 212, 214, 216, 218 before reaching the contact pads 202, 204, 206, 210 and the associated contacts 310.

Both simulated and experimental testing has shown that the lengths of conductive material 212, 214, 216, 218 provides a significant reduction in impedance discontinuities at the corresponding contact pads 202, 204, 206, 210 and associated contacts 310 by increasing inductance.

In contrast with the first, second, third, and fifth metal interconnects 340, 342, 344, 348, the fourth metal interconnect 346 (associated with the fourth contact pad 208) does not include a length of conductive material. Rather, the metal interconnect 346 is constructed according to known techniques with a via stack 350 that is directly coupled to the contact pad 208 in a straight line by a metal via 308 extending between the base metal layer 211 and the base-1 metal layer 302.

As shown in FIG. 2, in addition to the via pad 224 at the end of the length of conductive material 214 associated with the second contact pad 204, the second contact pad 204 is associated with a second via pad (e.g., the via pad 230) that protrudes off from and/or beyond the corresponding length of conductive material 214 near the point of attachment to the contact pad 204. As shown in FIGS. 3 and 5, this second via pad 230 is electrically coupled (through a metal via 308) to a stub 320 (implemented in the base-1 metal layer 302) that branches off the second metal interconnect 342 associated with the second contact pad 204. In this example, the stub 320 extends towards the fourth contact pad 208. As shown in the illustrated example of FIG. 3, the stub 320 includes a coupling pad 321 (e.g., coupling plate) that overlaps the fourth contact pad 208. However, as shown in FIG. 5, the stub 320 (including the coupling pad 321) remains electrically isolated from the fourth contact pad 208 and the associated fourth metal interconnect 346. The close proximity between the stub 320 and the fourth conductive pad 208 nevertheless provide a capacitive coupling therebetween to reduce crosstalk between the interconnects 342, 346.

In some examples, as in the case of the second metal interconnect 342 associated with the second contact pad 204, the length of conductive material 214 is used in combination with the stub 320 (e.g., a coupled via structure) to improve crosstalk while also reducing (e.g., minimizing) impedance discontinuities. That is, as discussed above, while the stub 320 serves to reduce crosstalk, the stub 320 results in a greater drop in impedance. However, the second length of conductive material 214 serves to compensate for that drop by increasing impedance. In other examples, as in the case of the first, third, and fifth metal interconnect 340, 344, 348, the stub 320 can be omitted, to achieve greater improvement to the impedance.

While an example arrangement of metal features are shown in the illustrated example of FIGS. 2-5, many variations are possible. For instance, one or more of the lengths of conductive material 212, 214, 216, 218 may be omitted and/or the fourth contact pad 208 may include a length of conductive material. Further, in some examples, the stub 320 can be implemented on a different contact pad and/or extend toward a different contact pad than shown in the illustrated example. Further, in some examples, more than one of the contact pads 202, 204, 206, 208, 210 can include a stub extend towards any other adjacent contact pad. Furthermore, in some examples, the location of the via pad 230 in the base metal layer 211 that provides the connection to the stub 320 can be at any other suitable location along the length of conductive material 214. In other examples, the via pad 230 can be connected to the contact pad 204 independent of and spaced apart from the length of conductive material 214. For instance, in some examples, the via pad 230 can correspond to an area on the contact pad 204. Additionally, in some examples, the stub 320 can be provided in a different metal layer than what is shown in the illustrated example. Similarly, in some examples, the traces 322, 324, 326, 328 electrically coupled the lengths of conductive material 212, 214, 216, 218 with the corresponding via stacks 330, 332, 334, 336 can be in a different metal layer than what is shown. Further, in some examples, the via stacks 330, 332, 334, 336, 350 can be at some other location (other than aligned with the center of the contact pad 202, 204, 206, 208, 210). In some examples, the metal vias 308 and associated via pads 338 in the via stacks 330, 332, 334, 336, 350 can be separated to different locations (rather than being vertically aligned). In some examples, metal traces can extend within ones of the metal layers 302, 304, 306 to connect the laterally spaced apart via pads.

Additionally, in some examples, the point of attachment of the lengths of conductive material 212, 214, 216, 218 need not be at the specific locations shown in the figures, but can be at any suitable point along the perimeter 220 of the respective contact pads 202, 204, 206, 210. Further, the lengths of conductive material 212, 214, 216, 218 can be longer or shorter than what is shown in the illustrated examples. That is, in some examples, the lengths of conductive material 212, 214, 216, 218 can extend any suitable extent around the contact pads 202, 204, 206, 210 (e.g., at least 10% of the way around, at least 25% of the way around, less than halfway around, at least halfway around, at least 75% of the way around, at least 95% of the way around, etc.). In some examples, different ones of the lengths of conductive material 212, 214, 216, 218 extend different lengths around the respective contact pads 202, 204, 206, 210. In some examples, the lengths of conductive material 212, 214, 216, 218 extend more than one full rotation around the contact pads 202, 204, 206, 210. In some such examples, the second rotation is at a different radial distance from a center of the contact pads 202, 204, 206, 210. In some examples, the total length of a given one of the lengths of conductive material 212, 214, 216, 218 can be greater than the distance corresponding to the full perimeter 220 of the contact pad 212, 214, 216, 218, even when the length of conductive material 212, 214, 216, 218 extends less than the full way around the contact pad 220, by fabricating the length of conductive material 212, 214, 216, 218 in a serpentine or zig-zag pattern. Thus, in some examples, the lengths of the conductive material 212, 214, 216, 218 can have a total length that is any proportion (e.g., at least 5%, at least 10%, at least 15%, at least 25%, at least 50%, at least 75%, at least 90%, at least 100%, at least 125%, etc.) of a distance directly along the full perimeter 220 of a contact pad 212, 214, 216, 218. In some examples, the total length of a given one of the lengths of conductive material 212, 214, 216, 218 is designed to improve (e.g., optimize) the total inductance. That is, in some examples, the particular longitudinal length of the lengths of conductive material 212, 214, 216, 218 depends on how much inductive compensation is needed and the area available for such conductive material. Significantly, experimental testing has shown that, while the lengths of conductive material 212, 214, 216, 218 add to the overall length of the associated signal path, the structure of the resulting metal interconnect reduce insertion loss rather than increase. Specifically, in one specific example, the lengths of conductive material 212, 214, 216, 218 are approximately 2 millimeters long and result in a decrease in insertion loss by more than 2 decibels (dB) at 16 gigahertz (GHz) with the return loss improved by more than 7dB at 16GHz. Further, implementing such example lengths of conductive material 212, 214, 216, 218 in a double data rate 5 (DDR5) channel, the eye height and eye width margin were improved by 7.3 millivolts (mV) and 5.3 picoseconds (ps), respectively.

Further, in some examples, the gap or distance 410 (FIG. 4) between the lengths of conductive material 212, 214, 216, 218 and the perimeter 220 of the contact pads 202, 204, 206, 210 can be any suitable distance. In some examples, this distance 410 is less than a width 412 of the lengths of conductive material 212, 214, 216, 218. In other examples, the distance 410 is equal to or greater than the width 412 of the lengths of conductive material 212, 214, 216, 218 (e.g., at least twice the width 412, at least three times the width 412, at least five times the width 412, at least ten times the width 412, etc.). In some examples, the width 412 of the lengths of conductive material 212, 214, 216, 218 corresponds to the width of traces provided elsewhere in the IC package 100. In other examples, the width 412 can be greater or less than the width of traces. In some examples, the width 412 is one parameter that can be designed to achieve a particular impedance compensation based on the circuit design and associated design constraints. In the illustrated example, the distance 410 remains substantially constant because the path of the lengths of conductive material 212, 214, 216, 218 follows the shape of the perimeter 220 of the contact pads 202, 204, 206, 210. That is, in this example, the lengths of conductive material 212, 214, 216, 218 follows an arc that is concentrically aligned with the circular contact pads 202, 204, 206, 210. However, in some examples, the lengths of conductive material 212, 214, 216, 218 can be a shape other than the shape of the perimeter 220 though still generally following a course defined by the shape of the perimeter 220 so as to extend around the contact pad 202, 204, 206, 210 (e.g., the lengths of conductive material can be square, hexagonal, or other polygon shape, define a serpentine or zig-zag path, and/or any other suitable shape that includes straight section and/or curved sections). In such examples, the distance 410 may depend upon the location along the length of conductive material 212, 214, 216, 218. In some examples, regardless of the distance 410 at any given location, the lengths of conductive material 212, 214, 216, 218 remain within a threshold distance of the perimeter 220. That is, in some examples, the distance 410 plus the width 412 is maintained within a threshold distance of the perimeter 220 of the contact pads 202, 204, 206, 210 along at least a majority of the length of conductive material. In some examples, the threshold distance is less than half a width 414 of the contact pad 202, 204, 206, 210. In some examples, the threshold distance is more than half the width 414. In other examples, the threshold distance is even less (e.g., one third the width 414, one quarter the width 414, etc.). In some examples, the threshold distance is such that an entirety of the lengths of conductive material 212, 214, 216, 218 are closer to the respective contact pad 202, 204, 206, 210 to which each length of conductive material 212, 214, 216, 218 is connected than the length of conductive material 212, 214, 216, 218 is to any of the other adjacent contact pads.

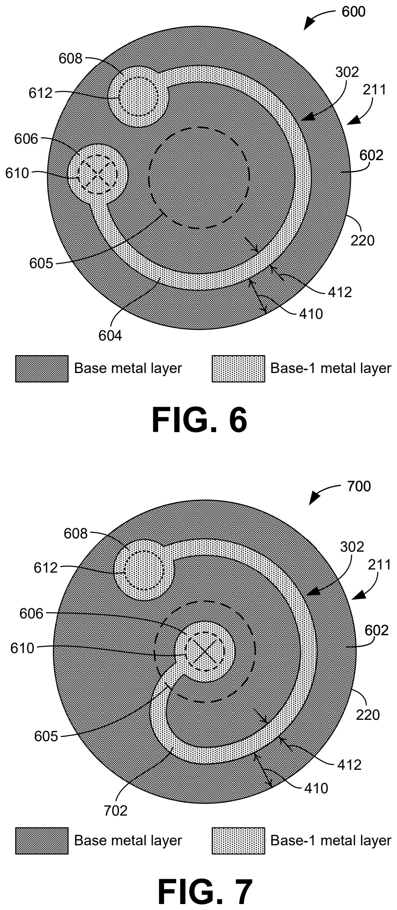

FIG. 6 is a top view of an example metal interconnect 600 including a contact pad 602 coupled to an example length of conductive material 604 (e.g., metal curl, inductive compensation structures) constructed in accordance with teachings disclosed herein. The contact pad 602 represents an example implementation of the contact pads 122 associated with the first contacts 104 in FIG. 1 and/or the contact pads 126 associated with the third contacts 120 in FIG. 1. In this example, the contact pad 602 is in the base metal layer 211 and the length of conductive material 604 is in the base-1 metal layer 302.

As shown in the illustrated example, the length of conductive material 604 includes first and second via pads 606, 608 at respective first and second end of the length of conductive material 604. As discussed above in connection with FIG. 2, the via pads 606, 608 are locations where a via (e.g., the metal vias 308 shown in FIGS. 3-5) electrically connect metal in different metal layers. In the illustrated example of FIG. 6, the dashed circle 610 with an "X" inside represents the location of a metal vias extending between the base metal layer 211 (containing the contact pad 602) and the base-1 metal layer 302 (containing the length of conductive material 604). The dashed circle 612 without an "X" represents the location of a metal vias extending from the base-1 metal layer 302 (containing the length of conductive material 604) up to another metal layer (e.g., the base-2 metal layer). Thus, for purposes of explanation, the dashed circle 610 with the "X" inside represent a via extend into the drawing (e.g., underneath or behind the base-1 metal layer 302 from the perspective shown in FIG. 6) and the dashed circle 612 without the "X" represents a via extend out of the drawing (e.g., above or in front of the base-1 metal layer 302 from the perspective shown in FIG. 6). Thus, the length of conductive material 604 defines a segment of a conductive path along which electrical signals may travel to or from the contact pad 602 and upper metal layers.

Similar to the example lengths of conductive material 212, 214, 216, 218 shown in FIGS. 2-5, the length of conductive material 604 of FIG. 6 extends along or follows a trace generally corresponding to the perimeter 220 of the contact pad 602. However, unlike the examples of FIGS. 2-5, the length of conductive material 604 in FIG. 6 is within an area defined by the perimeter 220 of the contact pad 602. That is, in this example, the length of conductive material 604 is closer to a center of the contact pad 602 than the perimeter 220 is to the center of the contact pad 602. In other words, in this example, while the length of conductive material 604 does not extend around an exterior of the contact pad 602, the length of conductive material 604 nevertheless extends (at least partially) around a central region 605 of the contact pad 602. Although within the perimeter 220, in some examples, the length of conductive material 604 is closer to the perimeter 220 of the contact pad 602 than the length of conductive material 604 is to the center of the contact pad 602. In some examples, the length of conductive material 604 is aligned with the perimeter 220 of the contact pad 602 (e.g., the length of conductive material 604 is a same distance from the center of the contact pad 602 as the perimeter 220 is to the center of the contact pad). In some examples, the length of conductive material 604 extends outward beyond the perimeter 220. In some examples, the outer boundary of the length of conductive material 604 is defined by a boundary of a metal void region above the contact pad 602.

In the illustrated example of FIG. 6, both of the via pads 606, 608 at either end of the length of conductive material 604 are a same distance from the center of the contact pad 602. In other examples, other arrangements are possible. For instance, FIG. 7 is a top view of another example metal interconnect 700 that is substantially the same as the metal interconnect 600 of FIG. 6 except as noted below or otherwise made clear from the context. Accordingly, the same reference numbers are used for the same or similar features and the description of such features provided above applies equally to the corresponding features in FIG. 7. The example shown in FIG. 7 differs from the example shown in FIG. 6 in that the first via pad 606 is positioned at the center of the contact pad 602 while the second via pad 608 remains adjacent the perimeter 220 of the contact pad 602. As a result of the placement of the via pads 606, 608, the example metal interconnect 700 of FIG. 7 has a different shaped length of conductive material 702 as compared to the length of conductive material 604 in FIG. 6. Specifically, the length of conductive material 702 of FIG. 7 curves or spirals inward along its length from the second via pad 608 to the first via pad 606. In some examples, rather than the full length of conductive material 702 being curved, at least a portion of the length of conductive material 702 includes a straight section. For instance, in some examples, the length of conductive material 702 follows a similar circular arc shown in FIG. 6 but that includes an abrupt turn and a straight section that extends toward the first via pad 606 at the center of the contact pad 602.

Many different arrangements and/or shapes for the metal features shown in FIG. 6 and 7 are possible in a similar manner to the variations described above in connection with FIGS. 2-5. For instance, in some examples, an additional via pad can branch off from either of the lengths of conductive material 604, 702 to provide a location for a stub (e.g., similar to the stub 320) that enables a coupled-via structure). Inasmuch as the lengths of conductive material 604, 702 are already in the base-1 metal layer 302, in some examples, such a stub can branch off directly from the lengths of conductive material 604, 702 without the need for an intervening via pad. Further, in some examples, either of the via pads 606, 608 can be at any suitable location other than what is shown in the illustrated examples. In some examples, the lengths of conductive material 604, 702 can be implemented in a different metal layer other than the base-1 metal layer 302.

Additionally, the lengths of conductive material 604, 702 can be longer or shorter than what is shown in the illustrated examples. That is, in some examples, the lengths of conductive material 604, 702 can extend any suitable extent around the contact pads 602 (e.g., at least 10% of the way around, at least 25% of the way around, less than halfway around, at least halfway around, at least 75% of the way around, at least 95% of the way around, etc.). In some examples, the lengths of conductive material 604, 702 extend more than one full rotation around the contact pad 602. That is, the lengths of conductive material 604, 702 can follow a spiral path in which different rotations are at different radial distances from the center of the contact pad 602. In some examples, a first portion of the length of conductive material 604, 702 is within the perimeter 220 of the contact pad 602 while a second portion is beyond the perimeter 220. More generally, as discussed above, the total length of the lengths of conductive material 604, 702 can be any suitable length to improve (e.g., optimize) the total inductance.

Further, in some examples, the gap or distance 410 (FIG. 4) between the length of conductive material 604, 702 and the perimeter 220 of the contact pad 602 can be any suitable distance. In some examples, this distance 410 is less than a width 412 of the length of conductive material 604, 702. In other examples, the distance 410 is equal to or greater than the width 412 of the length of conductive material 604, 702 (e.g., at least twice the width 412, at least three times the width 412, at least five times the width 412, at least ten times the width 412, etc.). In some examples, the width 412 of the length of conductive material 604, 702 corresponds to the width of traces provided elsewhere in the IC package 100. In other examples, the width 412 can be greater or less than the width of traces. In some examples, the width 412 is one parameter that can be designed to achieve a particular impedance compensation based on the circuit design and associated design constraints. In the illustrated example, the distance 410 remains substantially constant for at least a portion of the length of conductive material 604, 702 because the path of the length of conductive material 604, 702 follows the shape of the perimeter 220 of the contact pad 602. That is, in this example, the length of conductive material 604, 702 follows an arc that is concentrically aligned with the circular contact pads 202, 204, 206, 210. However, in some examples, the lengths of conductive material 212, 214, 216, 218 can be a shape other than the shape of the perimeter 220 though still generally corresponding to the shape so as to extend around the contact pad 202, 204, 206, 210 (e.g., the lengths of conductive material can be square, hexagonal, or other polygon shape, define a serpentine or zig-zag path, and/or any other suitable shape that includes straight section and/or curved sections). In such examples, the distance 410 may depend upon the location along the length of conductive material 604, 702. In some examples, regardless of the distance 410 at any given location, the length of conductive material 604, 702 remains within a threshold distance of the perimeter 220. That is, in some examples, the distance 410 plus the width 412 is maintained within a threshold distance of the perimeter 220 of the contact pad 602 along at least a majority of the length of conductive material. In some examples, the threshold distance is less than half a width of the contact pad 602. In some examples, the threshold distance is more than half the width of the contact pad 602 or even less (e.g., equal to or less than one third the width of the contact pad 602, equal to or less than one quarter the width of the contact pad 602, etc.).

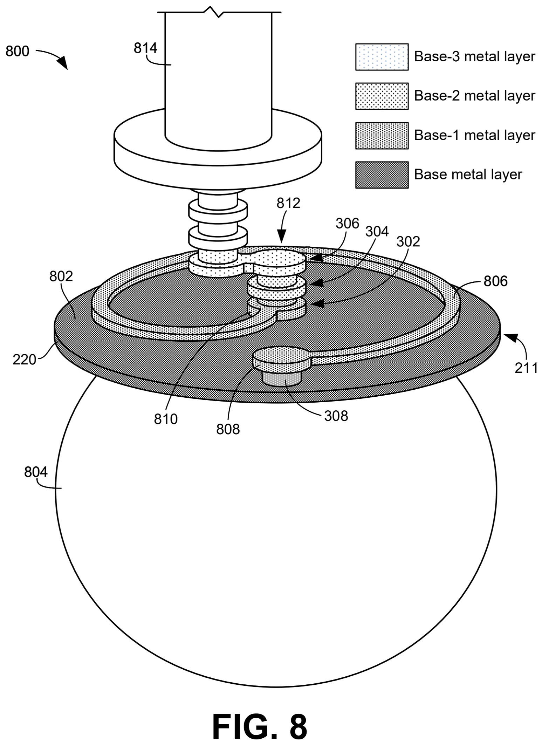

FIG. 8 is a top perspective view of another example metal interconnect 800 constructed in accordance with teachings disclosed herein. In this example, the metal interconnect 800 including a contact pad 802 in the base metal layer 211 and connected to a contact 804 (e.g., a solder ball) that represents an example implementation of the contact pads 122 associated with the first contacts 104 in FIG. 1 and/or the contact pads 126 associated with the third contacts 120 in FIG. 1. Further, in this example, the metal interconnect 800 includes a lengths of conductive material 806 within the base-1 metal layer 302 at a location within the metal void region above the contact pad 802. The lengths of conductive material 806 of FIG. 8 is similar to the length of conductive material 702 of FIG. 7 in that one via pad 808 is adjacent a perimeter 220 of the contact pad 802 and the other via pad 810 at the opposite end of the length of conductive material 806 is at the center of the contact pad 802. However, unlike the example shown in FIG. 7, the outer via pad 808 is electrically coupled to the contact pad 802 by a metal via 308 extending therebetween, whereas the central via pad 810 is not directly coupled to the contact pad 802 by a metal via. However, the central via pad 810 is the bottom via pad in a via stack 812 that extends up through the base-2 and base-3 metal layers 304, 306. For purposes of clarity, the shading of the different metal layers 211, 302, 304, 306 shown in FIG. 8 follows the shading used in FIG. 3-5 as outlined above. The example metal interconnect 800 shown in FIG. 8 shows metal vias and via pads extend up through additional metal layers without any shading. Further, in this example, the metal interconnect 800 includes a plated through-hole (PTH) 814.

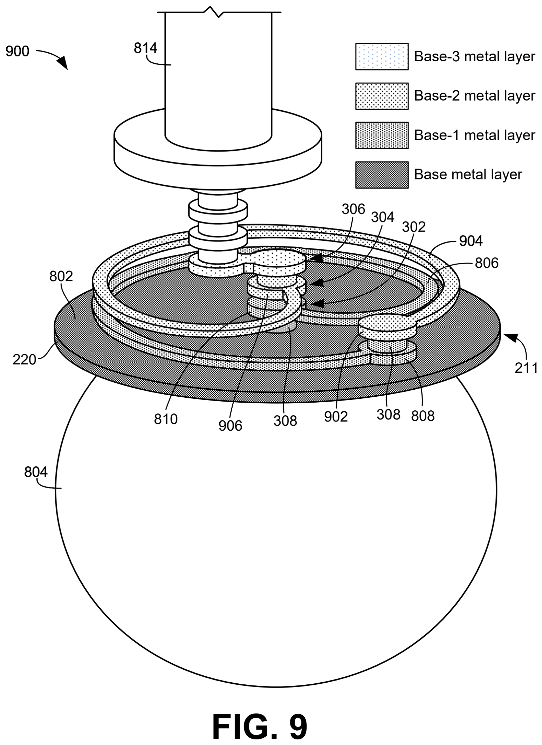

FIG. 9 is a top perspective view of another example metal interconnect 900 constructed in accordance with teachings disclosed herein. The metal interconnect 900 of FIG. 9 is substantially the same as the metal interconnect 800 of FIG. 8 except as noted below or otherwise made clear from the context. Accordingly, the same reference numbers are used for the same or similar features and the description of such features provided above applies equally to the corresponding features in FIG. 9. The example shown in FIG. 9 differs from the example shown in FIG. 8 in that the length of conductive material 806 spirals inward from the outer via pad 808 toward the central via pad 810 in the opposite direction. Further, whereas the outer via pad 808 in FIG. 8 was directly connected to the contact pad 802, in the example of FIG. 9, the central via pad 810 is directly connected to the contact pad 802 by an associated metal via 308. Additionally, the outer via pad 808 is associated with a second metal via 308 that extends up to another via pad 902 in the base-2 metal layer 304. In this example, the via pad 902 in the base-2 metal layer 304 is at a first end of a second length of conductive material 904 in the base-2 metal layer 304. In this example, the second length of conductive material 904 spirals inward toward another via pad 906 aligned with the center of the contact pad 602. Thus, in this example, there are two lengths of conductive material 806, 904 in two metal layers within the metal void region above the contact pad. In this example, the two lengths of conductive material 806, 904 are electrically coupled in series. Accordingly, both lengths of conductive material 806, 904 can be referred to as a single inductive loop or inductive coil that includes multiple turns or rotations. In some examples, lengths of conductive material can be included in more than two metal layers (e.g., to define an inductive loop or more than two turns or rotations).

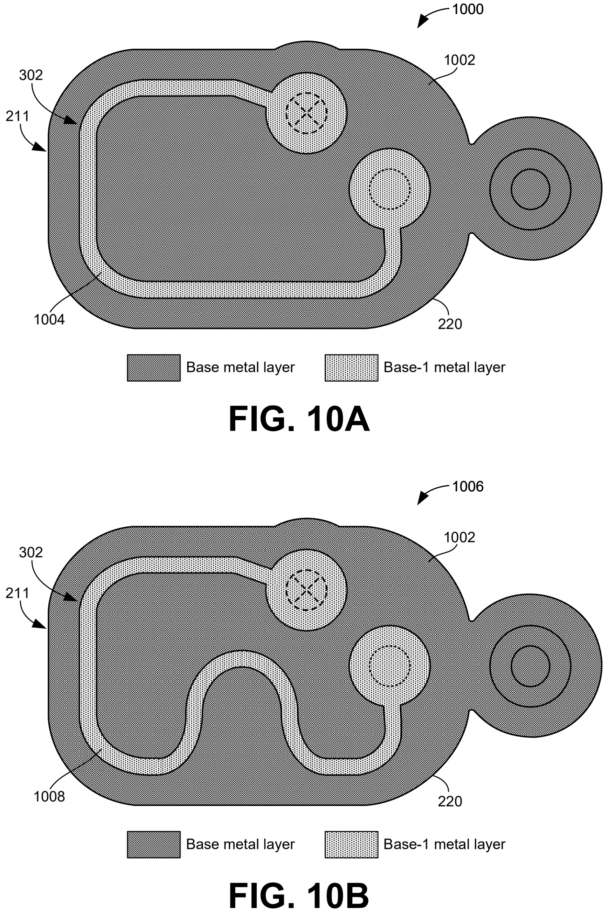

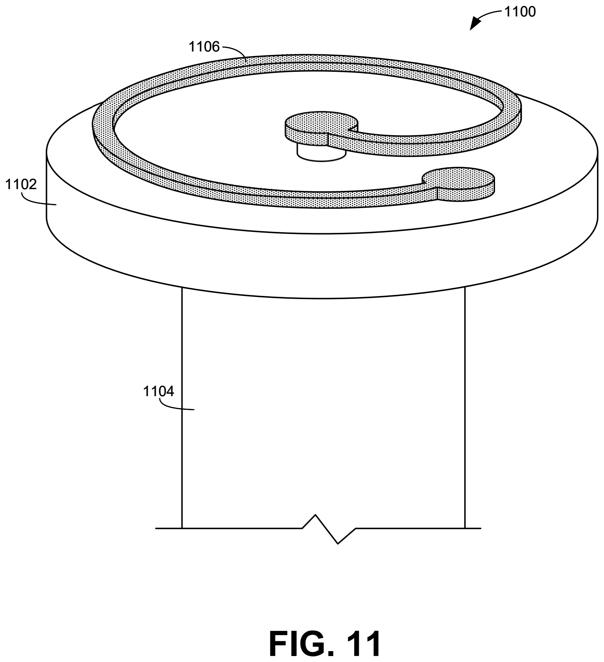

FIGS. 1-9 have been described primarily with reference to balls in a BGA. However, as discussed above, teachings disclosed herein are applicable to other types of large vertical structures in an IC package that can give rise to impedance discontinuities and/or crosstalk. FIGS. 10A, 10B, and 11 illustrate different types of such large vertical structures. Specifically, FIG. 10A is a top view of an example metal interconnect 1000 including a contact pad 1002 corresponding to an LGA land. In this example, the contact pad 1002 has a generally rectangular shape (rather than the circle shape of the contact pads of FIGS. 2-9). In other examples, the contact pads can be any other suitable shape. As shown in FIG. 10A, the contact pad 1002 is coupled to an example length of conductive material 1004 (e.g., metal curl, inductive compensation structures) constructed in accordance with teachings disclosed herein. In this example, the length of conductive material 1004 traces a path generally corresponding to the perimeter 220 of the contact pad 1002. Thus, while the full length of the length of conductive material 1004 is non-linear, the length of conductive material 1004 includes at least some portions that are straight due to the generally rectangular shape the length of conductive material follows. In this example, the contact pad 1002 is in the base metal layer 211 and the length of conductive material 1004 is in the base-1 metal layer 302. In other examples, the length of conductive material 1004 can be in a different metal layer. In some examples, the length of conductive material 1004 can be implemented within the base metal layer 211 and extend along a path outside the perimeter 220 of the contact pad 1002 similar to what is shown and described in connection with FIGS. 2-5. Further, the example metal interconnect 1000 of FIG. 10A can be suitable adapted in any other manner based on any of the variations and alternatives described above in connection with any of the examples of FIGS. 2-9.

FIG. 10B is a top view of another example metal interconnect 1006 that is substantially the same as the metal interconnect 1000 of FIG. 10A except as otherwise noted below. Specifically, the example metal interconnect 1006 of FIG. 10B includes the same contact pad 1002 as shown in FIG. 10A. However, the example metal interconnect 1006 of FIG. 10B includes a different shaped length of conductive material 1008. In this example, the length of conductive material 1008 defines a serpentine path with bends that extend towards and away from the perimeter 220 of the contact pad 1002. The serpentine path of the length of conductive material 1008 enables the total length between opposing ends of the length of conductive material 1008 to be increased relative to the length of the example shown in FIG. 10A. Any of the other example lengths of conductive material disclosed herein can similarly be modified with a serpentine and/or zig-zag path to adjust the total length as appropriate to achieve desired impedance compensation effects.

FIG. 11 is a top perspective view of another example metal interconnect 1100 including a contact pad 1102 at one end of a plated through-hole (PTH) 1104. As shown in FIG. 11, the contact pad 1102 is coupled to an example length of conductive material 1106 (e.g., metal curl, inductive compensation structures) constructed in accordance with teachings disclosed herein. In this example, the length of conductive material 1106 has the same general shape as the length of conductive material 702 of FIG. 7. However, in other examples, the length of conductive material 1106 of FIG. 11 can be modified according to any other lengths of conductive material disclosed herein and any of the variations and/or alternatives described above in connection with any of the examples of FIGS. 209. In some examples, the PTH 1104 corresponds to the PTH 814 of FIG. 8 and/or FIG. 9. That is, in some examples, different lengths of conductive material can be provided adjacent different large vertical structures along the same metal interconnect extending the full way through an IC package (e.g., the IC package 100 of FIG. 1) between a semiconductor die (e.g., either of the semiconductor dies 108, 110 of FIG. 1) and an external substrate (e.g., the substrate 102 of FIG. 1). In other words, in some examples, a single package can include two or more lengths of conductive material that can be spaced apart from one another by one or more other metal layers disposed therebetween. This is in contrast to the example shown in FIG. two or more lengths of conductive material can be in FIG. 9 where two metal layers are defined in adjacent metal layers with no other metal layers positioned therebetween.

The foregoing example contact pads 202, 204, 206, 208, 210, 602, 802, 1002, 1102 and the associated lengths of conductive material 212, 214, 216, 218, 604, 702, 806, 904, 1004, 1008, 1106 of FIGS. 2-11 teach or suggest different features. Although each example contact pad 202, 204, 206, 208, 210, 602, 802, 1002, 1102 and the associated lengths of conductive material 212, 214, 216, 218, 604, 702, 806, 904, 1004, 1008, 1106 disclosed above have certain features, it should be understood that it is not necessary for a particular feature of one example to be used exclusively with that example. Instead, any of the features described above and/or depicted in the drawings can be combined with any of the examples, in addition to or in substitution for any of the other features of those examples. One example's features are not mutually exclusive to another example's features. Instead, the scope of this disclosure encompasses any combination of any of the features.

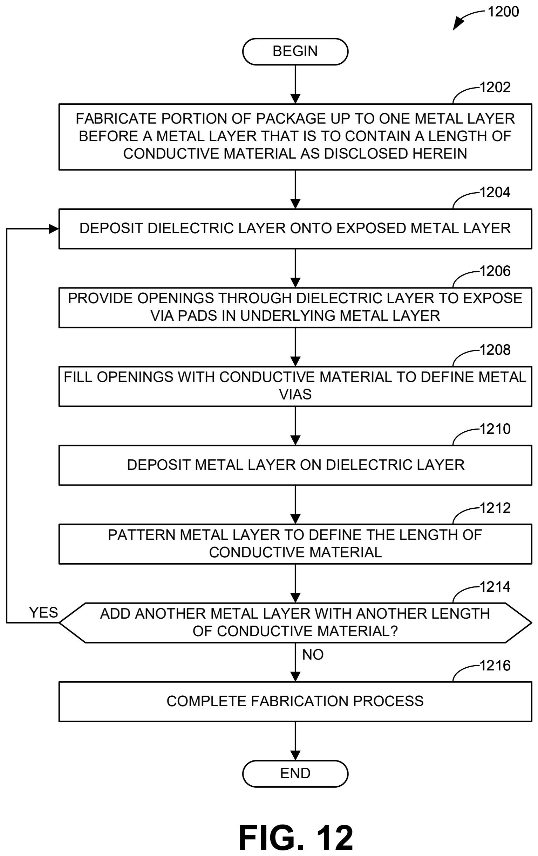

FIG. 12 is a flowchart representative of an example method 1200 of manufacturing the example IC package 100 of FIG. 1 that includes any of the example lengths of conductive material 212, 214, 216, 218, 604, 702, 806, 904, 1004, 1008, 1106 disclosed herein. In some examples, some or all of the operations outlined in the example method of FIG. 12 are performed automatically by fabrication equipment that is programmed to perform the operations. Although the example method of manufacture is described with reference to the flowchart illustrated in FIG. 12, many other methods may alternatively be used. For example, the order of execution of the blocks may be changed, and/or some of the blocks described may be combined, divided, re-arranged, omitted, eliminated, and/or implemented in any other way. Further, in some examples, additional processing operations can be performed before, between, and/or after any of the blocks represented in the illustrated example.

The example method 1200 of FIG. 12 begins at block 1202 by fabricating a portion of a package (e.g., an interposer, a package substrate, etc.) up to one metal layer before a metal layer that is to contain a length of conductive material 212, 214, 216, 218, 604, 702, 806, 904, 1004, 1008, 1106 as disclosed herein. At block 1204, the example method includes depositing a dielectric layer onto the exposed metal layer (e.g., the metal layer before the layer that is to include a length of conductive material). At block 1206, the example method includes providing openings through the dielectric layer to expose via pads in underlying metal layer. At block 1208, the example method includes filling the openings with conductive material to define metal vias. At block 1210, the example method includes depositing a metal layer on the dielectric layer. In some examples, the metal layer is deposited in the same operation as the filling of the openings at block 1208. At block 1212, the example method includes patterning the metal layer to define the length of conductive material. In some examples, the metal layer is lithographically patterned by etching away excess metal. In other examples, a mask is applied and patterned before the deposition of the metal. Thus, in some examples, the patterning of block 1212 is performed prior to the depositing of the metal layer at block 1210. At block 1214, the example method includes determining to add another metal layer with another length of conductive material. If so, the method returns to block 1204. Otherwise, the method advances to block 1216 to complete the fabrication process, which can include any number of additional operations.

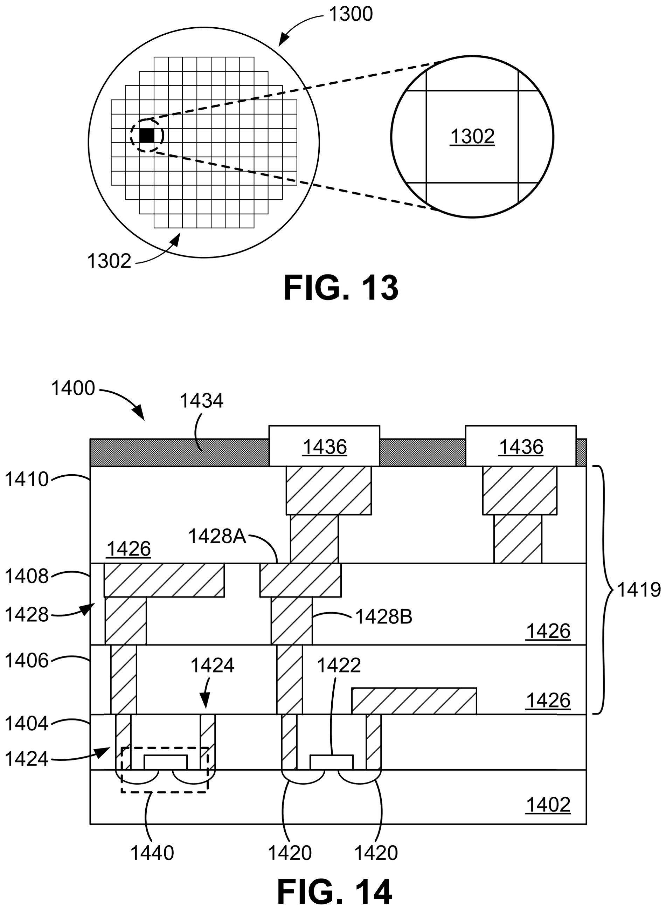

The example contact pads 202, 204, 206, 208, 210, 602, 802, 1002, 1102 and the associated lengths of conductive material 212, 214, 216, 218, 604, 702, 806, 904, 1004, 1008, 1106 disclosed herein may be included in any suitable electronic component. FIGS. 13-16 illustrate various examples of apparatus that may include or be included in the example IC package 100 of FIG. 1 that includes at least one of the example lengths of conductive material 212, 214, 216, 218, 604, 702, 806, 904, 1004, 1008, 1106 disclosed herein.

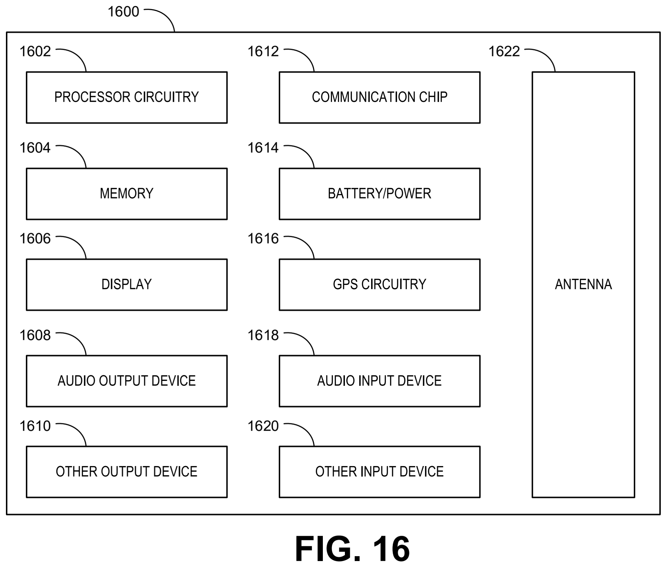

FIG. 13 is a top view of a wafer 1300 and dies 1302 that may be included in the IC package 100 of FIG. 1 (e.g., as any suitable ones of the dies 108, 110). The wafer 1300 includes semiconductor material and one or more dies 1302 having circuitry. Each of the dies 1302 may be a repeating unit of a semiconductor product. After the fabrication of the semiconductor product is complete, the wafer 1300 may undergo a singulation process in which the dies 1302 are separated from one another to provide discrete "chips." The die 1302 includes one or more transistors (e.g., some of the transistors 1440 of FIG. 14, discussed below), supporting circuitry to route electrical signals to the transistors, passive components (e.g., traces, resistors, capacitors, inductors, and/or other circuitry), and/or any other components. In some examples, the die 1302 may include and/or implement a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuitry or electronics. Multiple ones of these devices may be combined on a single die 1302. For example, a memory array of multiple memory circuits may be formed on a same die 1302 as programmable circuitry (e.g., the processor circuitry 1602 of FIG. 16) and/or other logic circuitry. Such memory may store information for use by the programmable circuitry. The example IC package 100 disclosed herein may be manufactured using a die-to-wafer assembly technique in which some dies are attached to a wafer 1300 that includes others of the dies, and the wafer 1300 is subsequently singulated.

FIG. 14 is a cross-sectional side view of an IC device 1400 that may be included in the example IC package 100 (e.g., in any one of the dies 108, 110). One or more of the IC devices 1400 may be included in one or more dies 1302 (FIG. 13). The IC device 1400 may be formed on a die substrate 1402 (e.g., the wafer 1300 of FIG. 13) and may be included in a die (e.g., the die 1302 of FIG. 13). The die substrate 1402 may be a semiconductor substrate including semiconductor materials including, for example, n-type or p-type materials systems (or a combination of both). The die substrate 1402 may include, for example, a crystalline substrate formed using a bulk silicon or a silicon-on-insulator (SOI) substructure. In some examples, the die substrate 1402 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the die substrate 1402. Although a few examples of materials from which the die substrate 1402 may be formed are described here, any material that may serve as a foundation for an IC device 1400 may be used. The die substrate 1402 may be part of a singulated die (e.g., the dies 1302 of FIG. 13) or a wafer (e.g., the wafer 1300 of FIG. 13).

The IC device 1400 may include one or more device layers 1404 disposed on and/or above the die substrate 1402. The device layer 1404 may include features of one or more transistors 1440 (e.g., metal oxide semiconductor field-effect transistors (MOSFETs)) formed on the die substrate 1402. The device layer 1404 may include, for example, one or more source and/or drain (S/D) regions 1420, a gate 1422 to control current flow between the S/D regions 1420, and one or more S/D contacts 1424 to route electrical signals to/from the S/D regions 1420. The transistors 1440 may include additional features not depicted for the sake of clarity, such as device isolation regions, gate contacts, and the like. The transistors 1440 are not limited to the type and configuration depicted in FIG. 14 and may include a wide variety of other types and/or configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1440 may include a gate 1422 including a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and/or zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and/or lead zinc niobate. In some examples, an annealing process may be carried out on the gate dielectric to improve its quality when a high-k material is used.

The gate electrode may be formed on the gate dielectric and may include at least one p-type work function metal or n-type work function metal, depending on whether the transistor 1440 is to be a p-type metal oxide semiconductor (PMOS) or an n-type metal oxide semiconductor (NMOS) transistor. In some implementations, the gate electrode may include a stack of two or more metal layers, where one or more metal layers are work function metal layers and at least one metal layer is a fill metal layer. Further metal layers may be included, such as a barrier layer. For a PMOS transistor, metals that may be used for the gate electrode include, but are not limited to, ruthenium, palladium, platinum, cobalt, nickel, conductive metal oxides (e.g., ruthenium oxide), and/or any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and/or aluminum carbide), and/or any of the metals discussed above with reference to a PMOS transistor (e.g., for work function tuning).

In some examples, when viewed as a cross-section of the transistor 1440 along the source-channel-drain direction, the gate electrode may include a U-shaped structure that includes a bottom portion substantially parallel to the surface of the die substrate 1402 and two sidewall portions that are substantially perpendicular to the top surface of the die substrate 1402. In other examples, at least one of the metal layers that form the gate electrode may be a planar layer that is substantially parallel to the top surface of the die substrate 1402 and does not include sidewall portions substantially perpendicular to the top surface of the die substrate 1402. In other examples, the gate electrode may include a combination of U-shaped structures and/or planar, non-U-shaped structures. For example, the gate electrode may include one or more U-shaped metal layers formed atop one or more planar, non-U-shaped layers.

In some examples, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and/or silicon oxynitride. Processes for forming sidewall spacers are well known in the art and generally include deposition and etching process operations. In some examples, a plurality of spacer pairs may be used; for instance, two pairs, three pairs, or four pairs of sidewall spacers may be formed on opposing sides of the gate stack.

The S/D regions 1420 may be formed within the die substrate 1402 adjacent to the gate 1422 of corresponding transistor(s) 1440. The S/D regions 1420 may be formed using an implantation/diffusion process or an etching/deposition process, for example. In the former process, dopants such as boron, aluminum, antimony, phosphorous, or arsenic may be ion-implanted into the die substrate 1402 to form the S/D regions 1420. An annealing process that activates the dopants and causes them to diffuse farther into the die substrate 1402 may follow the ion-implantation process. In the latter process, the die substrate 1402 may first be etched to form recesses at the locations of the S/D regions 1420. An epitaxial deposition process may then be carried out to fill the recesses with material that is used to fabricate the S/D regions 1420. In some implementations, the S/D regions 1420 may be fabricated using a silicon alloy such as silicon germanium or silicon carbide. In some examples, the epitaxially deposited silicon alloy may be doped in situ with dopants such as boron, arsenic, or phosphorous. In some examples, the S/D regions 1420 may be formed using one or more alternate semiconductor materials such as germanium or a group III-V material or alloy. In further examples, one or more layers of metal and/or metal alloys may be used to form the S/D regions 1420.

Electrical signals, such as power and/or input/output (I/O) signals, may be routed to and/or from the devices (e.g., transistors 1440) of the device layer 1404 through one or more interconnect layers disposed on the device layer 1404 (illustrated in FIG. 14 as interconnect layers 1406-1410). For example, electrically conductive features of the device layer 1404 (e.g., the gate 1422 and the S/D contacts 1424) may be electrically coupled with the interconnect structures 1428 of the interconnect layers 1406-1410. The one or more interconnect layers 1406-1410 may form a metallization stack (also referred to as an "ILD stack") 1419 of the IC device 1400.

The interconnect structures 1428 may be arranged within the interconnect layers 1406-1410 to route electrical signals according to a wide variety of designs (in particular, the arrangement is not limited to the particular configuration of interconnect structures 1428 depicted in FIG. 14). Although a particular number of interconnect layers 1406-1410 is depicted in FIG. 14, examples of the present disclosure include IC devices having more or fewer interconnect layers than depicted.

In some examples, the interconnect structures 1428 may include lines 1428a and/or vias 1428b filled with an electrically conductive material such as a metal. The lines 1428a may be arranged to route electrical signals in a direction of a plane that is substantially parallel with a surface of the die substrate 1402 upon which the device layer 1404 is formed. For example, the lines 1428a may route electrical signals in a direction in and/or out of the page from the perspective of FIG. 14. The vias 1428b may be arranged to route electrical signals in a direction of a plane that is substantially perpendicular to the surface of the die substrate 1402 upon which the device layer 1404 is formed. In some examples, the vias 1428b may electrically couple lines 1428a of different interconnect layers 1406-1410 together.

The interconnect layers 1406-1410 may include a dielectric material 1426 disposed between the interconnect structures 1428, as shown in FIG. 14. In some examples, the dielectric material 1426 disposed between the interconnect structures 1428 in different ones of the interconnect layers 1406-1410 may have different compositions; in other examples, the composition of the dielectric material 1426 between different interconnect layers 1406-1410 may be the same.

A first interconnect layer 1406 (referred to as Metal 1 or "M1") may be formed directly on the device layer 1404. In some examples, the first interconnect layer 1406 may include lines 1428a and/or vias 1428b, as shown. The lines 1428a of the first interconnect layer 1406 may be coupled with contacts (e.g., the S/D contacts 1424) of the device layer 1404.

A second interconnect layer 1408 (referred to as Metal 2 or "M2") may be formed directly on the first interconnect layer 1406. In some examples, the second interconnect layer 1408 may include vias 1428b to couple the lines 1428a of the second interconnect layer 1408 with the lines 1428a of the first interconnect layer 1406. Although the lines 1428a and the vias 1428b are structurally delineated with a line within each interconnect layer (e.g., within the second interconnect layer 1408) for the sake of clarity, the lines 1428a and the vias 1428b may be structurally and/or materially contiguous (e.g., simultaneously filled during a dual-damascene process) in some examples.

A third interconnect layer 1410 (referred to as Metal 3 or "M3") (and additional interconnect layers, as desired) may be formed in succession on the second interconnect layer 1408 according to similar techniques and/or configurations described in connection with the second interconnect layer 1408 or the first interconnect layer 1406. In some examples, the interconnect layers that are "higher up" in the metallization stack 1419 in the IC device 1400 (i.e., further away from the device layer 1404) may be thicker.

The IC device 1400 may include a solder resist material 1434 (e.g., polyimide or similar material) and one or more conductive contacts 1436 formed on the interconnect layers 1406-1410. In FIG. 14, the conductive contacts 1436 are illustrated as taking the form of bond pads. The conductive contacts 1436 may be electrically coupled with the interconnect structures 1428 and configured to route the electrical signals of the transistor(s) 1440 to other external devices. For example, solder bonds may be formed on the one or more conductive contacts 1436 to mechanically and/or electrically couple a chip including the IC device 1400 with another component (e.g., a circuit board). The IC device 1400 may include additional or alternate structures to route the electrical signals from the interconnect layers 1406-1410; for example, the conductive contacts 1436 may include other analogous features (e.g., posts) that route the electrical signals to external components.

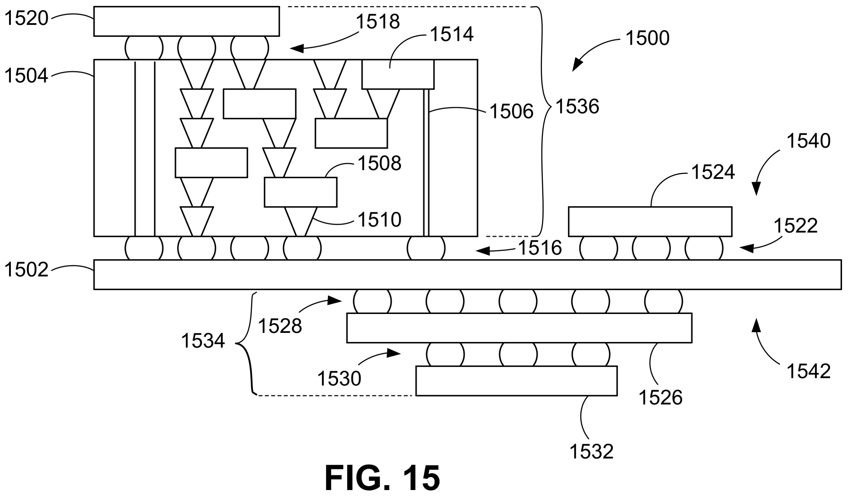

FIG. 15 is a cross-sectional side view of an IC device assembly 1500 that may include the IC package 100 disclosed herein. In some examples, the IC device assembly corresponds to the IC package 100. The IC device assembly 1500 includes a number of components disposed on a circuit board 1502 (which may be, for example, a motherboard). The IC device assembly 1500 includes components disposed on a first face 1540 of the circuit board 1502 and an opposing second face 1542 of the circuit board 1502; generally, components may be disposed on one or both faces 1540 and 1542. Any of the IC packages discussed below with reference to the IC device assembly 1500 may take the form of the example IC package 100 of FIG. 1.

In some examples, the circuit board 1502 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1502. In other examples, the circuit board 1502 may be a non-PCB substrate.

The IC device assembly 1500 illustrated in FIG. 15 includes a package-on-interposer structure 1536 coupled to the first face 1540 of the circuit board 1502 by coupling components 1516. The coupling components 1516 may electrically and mechanically couple the package-on-interposer structure 1536 to the circuit board 1502, and may include solder balls (as shown in FIG. 15), male and female portions of a socket, an adhesive, an underfill material, and/or any other suitable electrical and/or mechanical coupling structure.

The package-on-interposer structure 1536 may include an IC package 1520 coupled to an interposer 1504 by coupling components 1518. The coupling components 1518 may take any suitable form for the application, such as the forms discussed above with reference to the coupling components 1516. Although a single IC package 1520 is shown in FIG. 15, multiple IC packages may be coupled to the interposer 1504; indeed, additional interposers may be coupled to the interposer 1504. The interposer 1504 may provide an intervening substrate used to bridge the circuit board 1502 and the IC package 1520. The IC package 1520 may be or include, for example, a die (the die 1302 of FIG. 13), an IC device (e.g., the IC device 1400 of FIG. 14), or any other suitable component. Generally, the interposer 1504 may spread a connection to a wider pitch or reroute a connection to a different connection. For example, the interposer 1504 may couple the IC package 1520 (e.g., a die) to a set of BGA conductive contacts of the coupling components 1516 for coupling to the circuit board 1502. In the example illustrated in FIG. 15, the IC package 1520 and the circuit board 1502 are attached to opposing sides of the interposer 1504; in other examples, the IC package 1520 and the circuit board 1502 may be attached to a same side of the interposer 1504. In some examples, three or more components may be interconnected by way of the interposer 1504.

In some examples, the interposer 1504 may be formed as a PCB, including multiple metal layers separated from one another by layers of dielectric material and interconnected by electrically conductive vias. In some examples, the interposer 1504 may be formed of an epoxy resin, a fiberglass-reinforced epoxy resin, an epoxy resin with inorganic fillers, a ceramic material, or a polymer material such as polyimide. In some examples, the interposer 1504 may be formed of alternate rigid or flexible materials that may include the same materials described above for use in a semiconductor substrate, such as silicon, germanium, and other group III-V and group IV materials. The interposer 1504 may include metal interconnects 1508 and vias 1510, including but not limited to through-silicon vias (TSVs) 1506. The interposer 1504 may further include embedded devices 1514, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1504. The package-on-interposer structure 1536 may take the form of any of the package-on-interposer structures known in the art.

The IC device assembly 1500 may include an IC package 1524 coupled to the first face 1540 of the circuit board 1502 by coupling components 1522. The coupling components 1522 may take the form of any of the examples discussed above with reference to the coupling components 1516, and the IC package 1524 may take the form of any of the examples discussed above with reference to the IC package 1520.

The IC device assembly 1500 illustrated in FIG. 15 includes a package-on-package structure 1534 coupled to the second face 1542 of the circuit board 1502 by coupling components 1528. The package-on-package structure 1534 may include a first IC package 1526 and a second IC package 1532 coupled together by coupling components 1530 such that the first IC package 1526 is disposed between the circuit board 1502 and the second IC package 1532. The coupling components 1528, 1530 may take the form of any of the examples of the coupling components 1516 discussed above, and the IC packages 1526, 1532 may take the form of any of the examples of the IC package 1520 discussed above. The package-on-package structure 1534 may be configured in accordance with any of the package-on-package structures known in the art.

FIG. 16 is a block diagram of an example electrical device 1600 that may include one or more of the example IC package 100. For example, any suitable ones of the components of the electrical device 1600 may include one or more of the device assemblies 1500, IC devices 1400, or dies 1302 disclosed herein, and may be arranged in the example IC package 100. A number of components are illustrated in FIG. 16 as included in the electrical device 1600, but any one or more of these components may be omitted or duplicated, as suitable for the application. In some examples, some or all of the components included in the electrical device 1600 may be attached to one or more motherboards. In some examples, some or all of these components are fabricated onto a single system-on-a-chip (SoC) die.

Additionally, in various examples, the electrical device 1600 may not include one or more of the components illustrated in FIG. 16, but the electrical device 1600 may include interface circuitry for coupling to the one or more components. For example, the electrical device 1600 may not include a display 1606, but may include display interface circuitry (e.g., a connector and driver circuitry) to which a display 1606 may be coupled. In another set of examples, the electrical device 1600 may not include an audio input device 1618 (e.g., microphone) or an audio output device 1608 (e.g., a speaker, a headset, earbuds, etc.), but may include audio input or output device interface circuitry (e.g., connectors and supporting circuitry) to which an audio input device 1618 or audio output device 1608 may be coupled.

The electrical device 1600 may include programmable circuitry 1602 (e.g., one or more processing devices). The programmable circuitry 1602 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1600 may include a memory 1604, which may itself include one or more memory devices such as volatile memory (e.g., dynamic random access memory (DRAM)), nonvolatile memory (e.g., read-only memory (ROM)), flash memory, solid state memory, and/or a hard drive. In some examples, the memory 1604 may include memory that shares a die with the programmable circuitry 1602. This memory may be used as cache memory and may include embedded dynamic random access memory (eDRAM) or spin transfer torque magnetic random access memory (STT-MRAM).

In some examples, the electrical device 1600 may include a communication chip 1612 (e.g., one or more communication chips). For example, the communication chip 1612 may be configured for managing wireless communications for the transfer of data to and from the electrical device 1600. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some examples they might not.

The communication chip 1612 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1612 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1612 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1612 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1612 may operate in accordance with other wireless protocols in other examples. The electrical device 1600 may include an antenna 1622 to facilitate wireless communications and/or to receive other wireless communications (such as AM or FM radio transmissions).

In some examples, the communication chip 1612 may manage wired communications, such as electrical, optical, or any other suitable communication protocols (e.g., the Ethernet). As noted above, the communication chip 1612 may include multiple communication chips. For instance, a first communication chip 1612 may be dedicated to shorter-range wireless communications such as Wi-Fi or Bluetooth, and a second communication chip 1612 may be dedicated to longer-range wireless communications such as global positioning system (GPS), EDGE, GPRS, CDMA, WiMAX, LTE, EV-DO, or others. In some examples, a first communication chip 1612 may be dedicated to wireless communications, and a second communication chip 1612 may be dedicated to wired communications.

The electrical device 1600 may include battery/power circuitry 1614. The battery/power circuitry 1614 may include one or more energy storage devices (e.g., batteries or capacitors) and/or circuitry for coupling components of the electrical device 1600 to an energy source separate from the electrical device 1600 (e.g., AC line power).

The electrical device 1600 may include a display 1606 (or corresponding interface circuitry, as discussed above). The display 1606 may include any visual indicators, such as a heads-up display, a computer monitor, a projector, a touchscreen display, a liquid crystal display (LCD), a light-emitting diode display, or a flat panel display.

The electrical device 1600 may include an audio output device 1608 (or corresponding interface circuitry, as discussed above). The audio output device 1608 may include any device that generates an audible indicator, such as speakers, headsets, or earbuds.

The electrical device 1600 may include an audio input device 1618 (or corresponding interface circuitry, as discussed above). The audio input device 1618 may include any device that generates a signal representative of a sound, such as microphones, microphone arrays, or digital instruments (e.g., instruments having a musical instrument digital interface (MIDI) output).

The electrical device 1600 may include GPS circuitry 1616. The GPS circuitry 1616 may be in communication with a satellite-based system and may receive a location of the electrical device 1600, as known in the art.

The electrical device 1600 may include any other output device 1610 (or corresponding interface circuitry, as discussed above). Examples of the other output device 1610 may include an audio codec, a video codec, a printer, a wired or wireless transmitter for providing information to other devices, or an additional storage device.

The electrical device 1600 may include any other input device 1620 (or corresponding interface circuitry, as discussed above). Examples of the other input device 1620 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1600 may have any desired form factor, such as a hand-held or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server or other networked computing component, a printer, a scanner, a monitor, a set-top box, an entertainment control unit, a vehicle control unit, a digital camera, a digital video recorder, or a wearable electrical device. In some examples, the electrical device 1600 may be any other electronic device that processes data.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that improve communication lines in IC packages by reducing impedance discontinuities associated with impedance drops at large vertical structures such as contact pads associated with balls in BGAs, lands in LGAs, and/or PTHs. Disclosed examples reduce impedance discontinuities by increasing inductance by including an inductive compensation structure in the form of an elongate length of conductive material (e.g., an inductive loop or curl) that wrap at least part way around a central region of the associated contact pad. In some examples, the length of conductive material is included in the same metal layer as the contact pad and extends around the exterior of the contact pad. In some examples, the length of conductive material is included in a different metal layer than the contact pad within an area bounded by the perimeter or outer edge of the contact pad.

Further examples and combinations thereof include the following:
Example 1 includes an apparatus comprising a metal interconnect within a substrate of an integrated circuit package, the metal interconnect including a contact pad in a first metal layer of the substrate and a via pad in a second metal layer of the substrate, the metal interconnect defining a conductive path for an electric signal that is to pass through both the contact pad and the via pad, and a conductive material having a length defining a segment of the conductive path between the contact pad and the via pad, at least a portion of the length of the conductive material extends along a course that corresponds and is adjacent to a portion of a perimeter of the contact pad.
Example 2 includes any preceding clause(s) of example 1, wherein the portion of the perimeter of the contact pad along which the length of the conductive material extends includes at least 25% of the perimeter of the contact pad.
Example 3 includes any preceding clause(s) of any one or more of examples 1-2, wherein the conductive material is within a threshold distance of the perimeter of the contact pad along a full length of the at least the portion of the conductive material, the threshold distance less than one third a width of the contact pad.
Example 4 includes any preceding clause(s) of any one or more of examples 1-3, wherein an entirety of the conductive material is within the threshold distance of the perimeter of the contact pad.
Example 5 includes any preceding clause(s) of any one or more of examples 1-4, wherein the at least the portion of the length of the conductive material is a first portion, a second portion of the length of the conductive material extending towards a center of the contact pad.
Example 6 includes any preceding clause(s) of any one or more of examples 1-5, wherein the at least the portion of the conductive material is farther away from a center of the contact pad than the perimeter of the contact pad is from the center of the contact pad.
Example 7 includes any preceding clause(s) of any one or more of examples 1-6, wherein conductive material is closer to a center of the contact pad than the perimeter of the contact pad is to the center of the contact pad.
Example 8 includes any preceding clause(s) of any one or more of examples 1-7, wherein the conductive material is a first length of conductive material, and the segment is a first segment, the apparatus including a second length of conductive material defining a second segment of the conductive path, the first and second lengths of conductive material in different metal layers of the substrate.
Example 9 includes any preceding clause(s) of any one or more of examples 1-8, wherein the different metal layers are directly adjacent with no other metal layer therebetween.
Example 10 includes any preceding clause(s) of any one or more of examples 1-9, wherein the different metal layers are separated by multiple other metal layers therebetween.
Example 11 includes any preceding clause(s) of any one or more of examples 1-10, wherein the contact pad is associated with a ball in a ball grid array on an exterior surface of the substrate.
Example 12 includes any preceding clause(s) of any one or more of examples 1-11, wherein the contact pad is associated with a land in a land grid array on an exterior surface of the substrate.
Example 13 includes any preceding clause(s) of any one or more of examples 1-12, wherein the contact pad is associated with a plated through-hole within the substrate.
Example 14 includes any preceding clause(s) of any one or more of examples 1-13, wherein the substrate is a package substrate of the integrated circuit package.
Example 15 includes any preceding clause(s) of any one or more of examples 1-14, wherein the substrate is an interposer on a package substrate of the integrated circuit package.
Example 16 includes an apparatus comprising a first contact pad in a first metal layer within a substrate of an integrated circuit package, and an inductor spaced apart from the first contact pad, the inductor in circuit with the first contact pad such that the inductor defines a conductive path for an electric signal that is to pass through the first contact pad and other metal layers within the substrate, an entirety of the inductor closer to the first contact pad than any other contact pads adjacent the first contact pad.
Example 17 includes any preceding clause(s) of example 16, wherein the inductor is defined by a metal trace in the first metal layer, the metal trace is connected to and branches out from a perimeter of the first contact pad.
Example 18 includes any preceding clause(s) of any one or more of examples 16-17, wherein the inductor is in a second metal layer different from the first metal layer.
Example 19 includes an apparatus comprising a contact pad in a first metal layer of an integrated circuit package, a via pad in a second metal layer, and an inductive loop, the contact pad electrically coupled to the via pad through the inductive loop, the inductive loop extending at least partially around a central region of the contact pad.
Example 20 includes any preceding clause(s) of example 19, wherein the inductive loop is in the second metal layer within an area defined by an outer edge of the contact pad.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus comprising:
a metal interconnect within a substrate of an integrated circuit package, the metal interconnect including a contact pad in a first metal layer of the substrate and a via pad in a second metal layer of the substrate, the metal interconnect defining a conductive path for an electric signal that is to pass through both the contact pad and the via pad; and
a conductive material having a length defining a segment of the conductive path between the contact pad and the via pad, at least a portion of the length of the conductive material extends along a course that corresponds and is adjacent to a portion of a perimeter of the contact pad.

2. The apparatus of claim 1, wherein the portion of the perimeter of the contact pad along which the length of the conductive material extends includes at least 25% of the perimeter of the contact pad.

3. The apparatus of any one of claims 1-2, wherein the conductive material is within a threshold distance of the perimeter of the contact pad along a full length of the at least the portion of the conductive material, the threshold distance less than one third a width of the contact pad.

4. The apparatus of claim 3, wherein an entirety of the conductive material is within the threshold distance of the perimeter of the contact pad.

5. The apparatus of any one of claims 1-4, wherein the at least the portion of the length of the conductive material is a first portion, a second portion of the length of the conductive material extending towards a center of the contact pad.

6. The apparatus of any one of claims 1-5, wherein the at least the portion of the conductive material is farther away from a center of the contact pad than the perimeter of the contact pad is from the center of the contact pad.

7. The apparatus of any one of claims 1-5, wherein conductive material is closer to a center of the contact pad than the perimeter of the contact pad is to the center of the contact pad.

8. The apparatus of any one of claims 1-7, wherein the conductive material is a first length of conductive material, and the segment is a first segment, the apparatus including a second length of conductive material defining a second segment of the conductive path, the first and second lengths of conductive material in different metal layers of the substrate.

9. The apparatus of claim 8, wherein the different metal layers are directly adjacent with no other metal layer therebetween.

10. The apparatus of claim 8, wherein the different metal layers are separated by multiple other metal layers therebetween.

11. The apparatus of any one of claims 1-10, wherein the contact pad is associated with a ball in a ball grid array on an exterior surface of the substrate.

12. The apparatus of any one of claims 1-10, wherein the contact pad is associated with a land in a land grid array on an exterior surface of the substrate.

13. The apparatus of any one of claim 1-10, wherein the contact pad is associated with a plated through-hole within the substrate.

14. The apparatus of any one of claim 1-13, wherein the substrate is a package substrate of the integrated circuit package.

15. The apparatus of any one of claim 1-13, wherein the substrate is at least one of a semiconductor die or an interposer in the integrated circuit package.
